(19) Europäisches Patentamt

European Patent Office

Office européen des brevets

(11) Publication number: **0 547 501 A2**

## (12) EUROPEAN PATENT APPLICATION

(21) Application number: **92121046.4**

(22) Date of filing: **10.12.92**

(51) Int. Cl.5: **H03K 19/017**

(30) Priority: **19.12.91 US 813286**

(43) Date of publication of application:
**23.06.93 Bulletin 93/25**

(84) Designated Contracting States:
**DE NL**

(71) Applicant: **NATIONAL SEMICONDUCTOR CORPORATION**
**2900 Semiconductor Drive, P.O. Box 58090**
**Santa Clara, California 95052-8090(US)**

(72) Inventor: **Ohannes, James R.**
**341 Fore Street, Apartment 7**
**Portland, ME 04101(US)**

Inventor: **Clukey, Stephen W.**
**105 Barn Stable Road**
**South Portland, ME 04106(US)**
Inventor: **Haacke, David**
**97 Central Street**
**Westbrook, ME 04092(US)**
Inventor: **Yarbrough, Roy Lee**
**Box 204A Notch Road**
**Hiram, ME -04041(US)**

(74) Representative: **Sparing Röhl Henseler**
**Patentanwälte European Patent Attorneys**
**Rethelstrasse 123**
**W-4000 Düsseldorf 1 (DE)**

(54) **BICMOS inverter with bipolar enhanced current.**

(57) Bipolar and MOS logic elements are mixed together in a (BICMOS) inverter circuit that yields CMOS output signals from small-sized CMOS elements that are supplemented by bipolar current enhancement. Improved speed is provided for a pullup MOS transistor by bipolar current enhancement that has an improved rise time at the output. A pull-down MOS transistor is provided with another bipolar enhancement to improve fall time on the output signal. Smaller CMOS transistors are employed and yet high speed is provided. An improved building block that is the basis for other circuitry, also of the mixed-element type, is the result. An improved clock supply circuit is formed from tandem stages, even and odd in number, from the building block inverter invention.

FIG 3

EP 0 547 501 A2

CROSS RELATED PATENTS/ APPLICATIONS OF A COMMON ASSIGNEE

This patent application is related to a US application of the same title having Serial Number         filed on December 6,1991.

Such application describes in detail a prior art CMOS inverter and an improved BICMOS inverter with bipolar enhanced current.

TECHNICAL FIELD

The present invention relates to a new and improved input translator, clock and inverter circuit of the mixed-element type. More particularly, the invention is formed in a small die area space and the invented circuit includes bipolar transistors in combination with CMOS devices (BICMOS) for improved speed of operation.

The technical field of our invention includes a CMOS inverter circuit combined with bipolar current enhancement. A novel inverter combination yields a basic building block that is useful in forming a series of electronic circuits, including, but not limited to, improved inverters, signal drivers, clock signal formers, input/output buffers, signal translation circuits, and the like.

BACKGROUND ART

As semi-conductor and "chip" technology has spread, many new discrete elements have been developed. Transistor-Transistor Logic (TTL) and CMOS elements are normally grouped in the logic family, while developments such as Field Effect Transistors (FET), and bipolar transistors are special discrete components. These various elements form many of today's more sophisticated electronic circuits that are fabricated as "chips".

Today's technology is witnessing hybrid, or mixed, circuits in which more and more of these diverse logic types are being combined with one another to yield combination circuits that exhibit improved performance. Although each element is a commonly known type in its own right, the mixed-element circuits present new and unusual challenges to inventors of "mixed-element" circuitry.

Inverters are basic building blocks for many logical functions and are in wide use today. It should be understood that while simple CMOS inverters can accomplish the results of the BICMOS inverters presented herein, such CMOS-only devices would have to be much larger or much slower (i.e. more stages). CMOS-only input devices may be constrained in size by Icct and capacitance specifications. It is, of course, desirable to reduce the size of the basic building block inverter devices without sacrificing performance, if at all possible. This BICMOS invention accomplishes these desirable goals.

Different type logic elements have different signal ranges for input and output levels. Moreover, logic devices of different types have different operating levels. TTL devices, for example, typically operate within a signal range of about 0.2 to 3.4 volts for input signal levels, while CMOS devices operate with signals ranging between 0 and Vcc, where Vcc is normally selected at about 4.5 to 5.5 volts. As one can well imagine, these different signal ranges present formidable technical difficulties which must be overcome if one is to successfully fabricate "mixed-element" BICMOS circuits.

Disparity in signal ranges, when diverse logic type elements are combined into a hybrid or mixed circuit, is just one of several design obstacles which must be overcome. Additionally, when smaller CMOS elements are employed, the speed and performance characteristics of different logic element types must be synergistically blended together in order to provide a successful mixed circuit design requiring small space yet presenting versatility and high speed.

In overcoming the disparity in signal ranges for mixed TTL-CMOS circuits, other problems present themselves. The extent and depth of such problems have heretofore discouraged TTL and CMOS from being combined into a new, efficient and successful high speed inverter building block of the type presented herein. For example, TTL devices operate at a lower input signal level than CMOS elements, thus requiring one to balance two different levels in circuit design involving both elements. Thus, the input threshold level may have to be different than the threshold level of subsequent stages. One must also meet stringent Icct specifications while still meeting speed and other signal requirements

We have overcome these various difficulties in our present invention, as it is defined by the claims, and have provided a mixed CMOS-TTL inverter circuit of improved design and performance. We have set our circuit input threshold level at about one-half of a TTL input range and this setting requires the use of a smaller than normal ratio-size of PMOS-to-NMOS in an inverter. Moreover, by selecting the PMOS in accordance with a particular Icct specification, a smaller than normal size PMOS transistor is required in meeting that Icct specification.

Additionally, our invention applies our improved inverter circuit invention to a signal translator, and a clock forming circuit in which our inverter invention is a stage of signal amplification and wherein adjacent stages are connected together in tandem.

## OBJECTS THE INVENTION MAY ADDRESS

It is one object to mix TTL and MOS logic elements together in an inverter circuit that operates as fast as possible while using the smallest device sizes that are possible for such a fast speed.

It is another object to mix TTL and MOS logic elements together in a novel inverter circuit having bipolar current enhancement and pullup/pull-down MOS transistors both of a smaller size. Another embodiment includes pullup/pull-down MOS transistors of reduced size with bipolar enhancement that relies upon a load discharge for pull-down.

It is a further object to use bipolar current enhancement in order to eliminate the requirement for extra stages of gain and reduce the amount of signal propagation delay inherent in several stages of gain.

It is also an object to provide a fast TTL to CMOS translation, with a TTL input signal threshold of about 1.5 volts, a low value for Icct and CMOS output levels of ground and Vcc.

It is still another object to mix TTL and MOS logic elements together in a novel inverter circuit including bipolar current enhanced pullup and pull-down for geometrically small MOS elements which save chip space.

It is still a further object to markedly reduce the size of CMOS pull-up and pull-down elements and additionally use a smaller than normal size of PMOS in relationship to NMOS while meeting or surpassing standard inverter capabilities.

Additional objects feature a mixed TTL and CMOS inverter as an improved building block that is the basis for input and output stages in other more complex circuitry, which circuitry is also characterized as being of the mixed-element type.

## DISCLOSURE OF THE INVENTION

This method and apparatus invention reflects a robust and fast performing inverter circuit formed by combining TTL speed-up transistors with a CMOS inverter circuit having small CMOS elements requiring only a small die area in fabrication. A preferred embodiment will hereinunder be briefly discussed.

Two series-connected MOS transistors (one N and one P), adapted for alternate conduction in response to TTL- type input signals have their gate leads tied together and to an input terminal; their drain leads tied together forming an output terminal, and such elements are adapted for standard pullup and pull-down at CMOS signal levels. The inverter of our invention is characterized by having fast-acting bipolar current enhancers connected in parallel with the pullup/pull-down MOS side(s) for delivering increased pullup/pull-down current to and from a load.

Inverter circuit speed and lower power consumption is improved by employing a control path to the base of a bipolar transistor that has it's current amplification path coupled between Vcc and the hybrid inverter's output terminal. Bipolar current amplification is in parallel with the primary CMOS elements and is instrumental in promoting an improved pullup operation.

Inverter circuit speed and fan out is improved by employing a control path to the base of a bipolar transistor that has it's current amplification path coupled between ground and the hybrid inverter's output terminal. Bipolar current amplification is in parallel with the primary CMOS elements and is instrumental in promoting an improved pull-down operation by employing load discharge current as base drive for the bipolar pull-down transistor.

Implicit in the load is a ground terminal that affords a complete circuit for immediate charging of the load from Vcc. The charging sequence in our invention is: (1) initially through a bipolar transistor, (2) then through both a bipolar and a PMOS pullup element, and (3) completed through the PMOS element. As the load is being charged, the NMOS pull-down element is non-conducting. An improvement in rise times in comparison with the rise time for a prior art non-mixed element inverter device is provided by our invention. Fall time is similarly improved by bipolar-assisted pull-down.

Integrated circuit fabrication techniques for the invention are readily available to provide a small channel width CMOS inverter to control a bipolar transistor which acts as a fast switching current amplifier. Employing such a narrow-channel inverter for controlling the bipolar current gain amplifier, allows low level input signals to be quickly translated to higher level output signals.

This invention, in one specific embodiment, uses a smaller than normal size of PMOS in relationship to the size of NMOS pullup and pull-down transistors ("fractional ratio") in order to lower the threshold switching voltage. Our invention employs a fractional relationship of about one-half to one-third as the ratio of PMOS to NMOS.

We prefer employing smaller geometry for the channel widths of the MOS elements in order to reduce Icct and to save space on the chip. In mixed MOS and TTL bipolar transistor circuitry, the pullup PMOS element, when made from a small amount of material, initiates a relatively small sourcing current to the output and is too slow. Because such smaller elements are slower, we use bipolar devices to make up for the loss of speed resulting from our smaller-sized CMOS elements.

The improved inverter invention is a basic building block that can be readily used to form other circuits of improved operation. Thus, a simple two output clock supply circuit is disclosed that uses the features of our invention and provide signal level translation from TTL input levels to CMOS output levels. Our complementary clock circuit has sufficiently high power to deliver complementary clock signals with very steep rise and fall times.

## BRIEF DESCRIPTION OF THE DRAWING

Figure 1 is a prior art inverter using P and N CMOS transistor elements.

Figure 2 is an improved BICMOS inverter circuit in accordance with the afore-mentioned Ward and Mentzer application.

Figure 3 is an improved BICMOS inverter circuit having PMOS and NMOS amounts and a fractional P/N ratio for a lower TTL input threshold and a CMOS output in accordance with the invention.

Figure 4 includes Figures 4A and AB. Figure 4A is a representative graph signal shape useful in describing a TTL input signal, the translation to a CMOS output level, and depicting a steep rise time in an output signal for the invention in comparison with the prior art.

Figure 4B is another representative signal shape useful in describing a TTL input level, the translation to a CMOS output level, and depicting a steep fall time in an output signal for the invention in comparison with the prior art.

Figure 5 depicts an improved inverter with bipolar enhanced pullup, and load discharge bipolar enhanced pull-down in accordance with the invention.

Figure 6 is a clock supply circuit employing the hybrid inverter building block of our invention and having inversion stages in a pair of clock forming channels provided with bipolar-enhanced pullup and pull-down.

## DESCRIPTION OF PREFERRED EXAMPLE EMBODIMENTS AND BEST MODE OF THE INVENTION

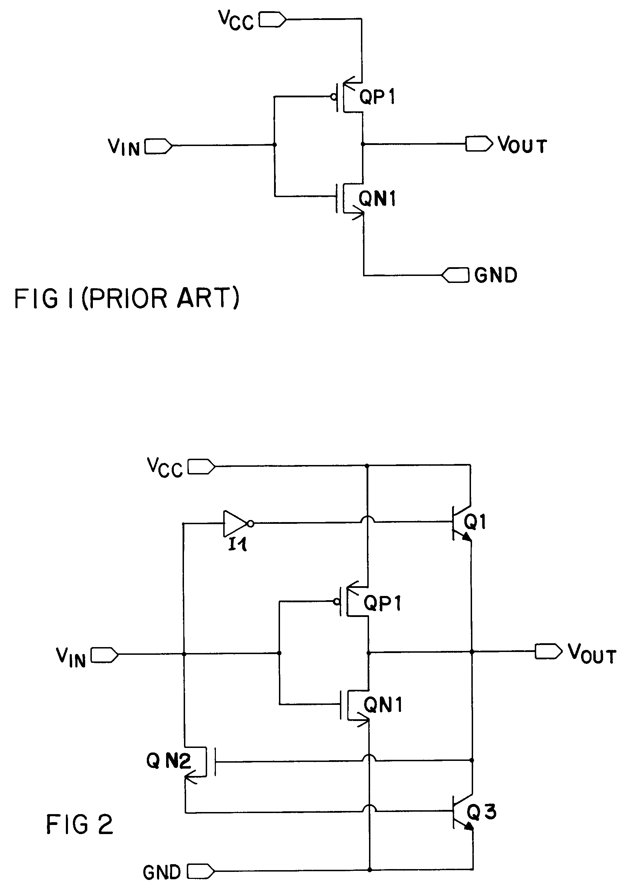

A prior art circuit is shown in Figure 1. An improved BICMOS hybrid inverter circuit with enhanced current pullup and pull-down operation in accordance with the Ward and Mentzer application is depicted in Figure 2.

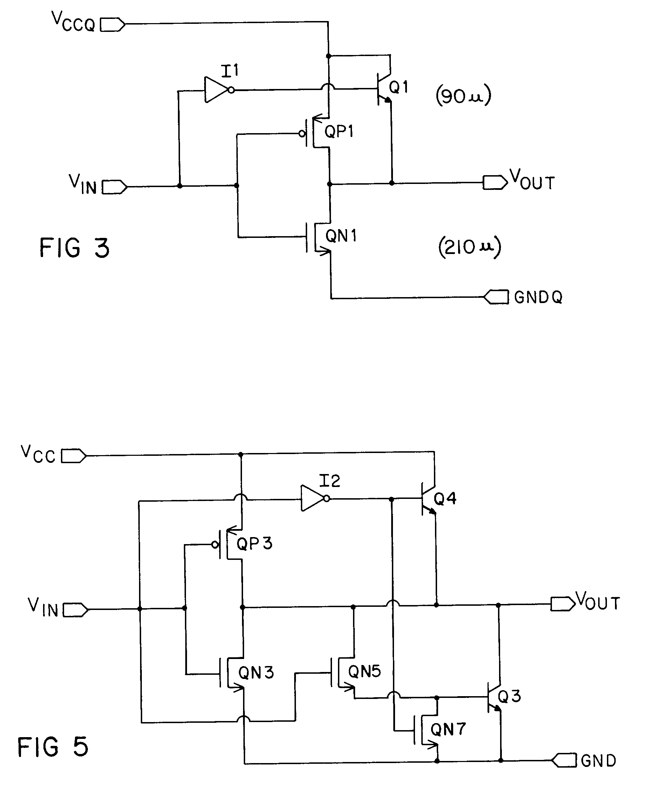

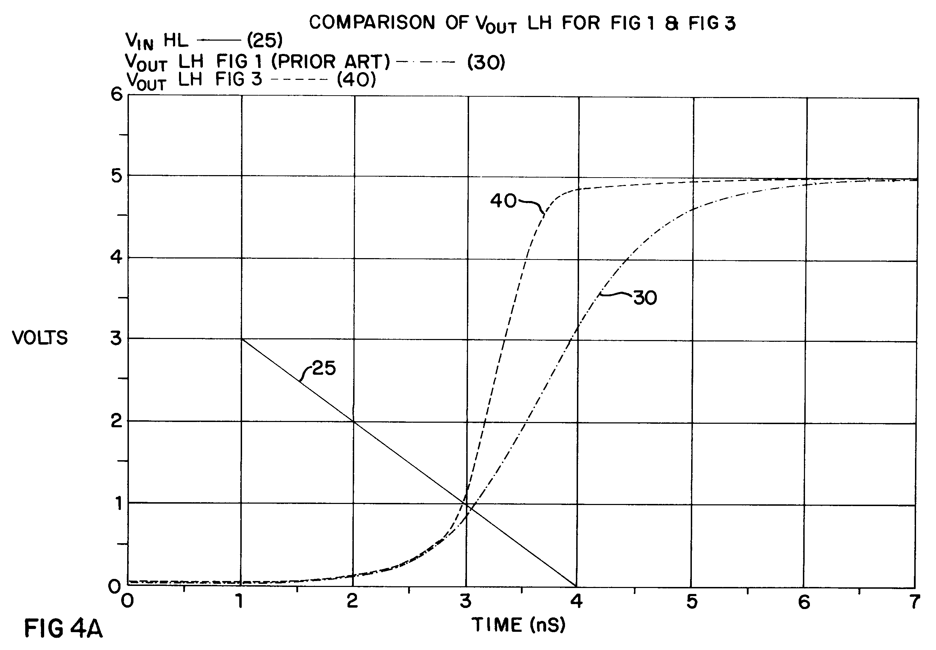

Our invention, depicted in Figures 3 through 6, expands upon and amplifies the Ward and Mentzer approach. For example, we accommodate TTL input signals and deliver CMOS output signals, and we employ smaller- sized P and NMOS devices with bipolar enhancement transistors without sacrificing speed or other performance criteria for our mixed-element circuit invention.

In the various circuits shown in the drawing of this application, circuit components performing the same or similar functions are often indicated by the same reference designation. In addition, it should be noted in passing that fabrication of CMOS transistors involves distinct regions of both N-type and P-type material of varying dimensions and configurations. In circuit schematics, a CMOS transistor is sometimes shown as having a so-called "bulk" connection terminal. Such a bulk connection would normally be depicted as an additional horizontal line parallel with and near the arrowhead. For clarity sake in the drawing, such lines have been left out from the symbols for the CMOS elements. The drawing without such additional lines, it is respectfully submitted, is simpler to understand and easier to follow.

The prior art Figure 1 depicts the basic circuit connections of a typical prior art inverter circuit in which an input terminal, Vin, is connected to the gate leads of a pair of CMOS elements having their drain leads connected together and in common to an output terminal, Vout. The current carrying leads of the CMOS elements are connected between a high current source, Vcc, and ground, Gnd.

Element QP1, Figure 1, is a P-type CMOS element and element QN1 is an N-type CMOS element. (In this specification such elements may sometimes be referred to simply as PMOS and NMOS devices.) Connected as shown in prior art Figure 1, the inverter circuit will alternately have one or the other of the CMOS elements in a conductive state depending upon the input signal level at the input terminal, Vin. For example, if the input signal at Vin is low then the P-type CMOS element, identified in Figure 1 as QP1, is "on" or conducting and the N-type CMOS, QN1, element is "off" or non-conducting. When the input signal at terminal, Vin, of prior art Figure 1 goes "high", the current conducting roles of the CMOS elements reverse.

Figure 2 of the Ward and Mentzer application employs the same CMOS pullup and pull-down operation as that for Figure 1. Highly summarized, the invention disclosed and claimed in the Ward and Mentzer application, includes TTL and MOS logic elements forming a (BICMOS) inverter circuit that is provided with a CMOS conduction path, for CMOS current, and bipolar transistors with their current amplification paths in parallel with the CMOS conduction path for enhanced current to and from an output terminal. These first and second bipolar transistors respond to input signals that are applied to their bases for providing bipolar enhanced pullup and pull-down current, thus improving load charging/discharging at an output terminal, Vout. Increased fan out in the order of one magnitude is readily provided by the novel current enhancement feature of Figure 2.

Figure 2, is fully described in the Ward and Mentzer application and reference may be made thereto for a detailed operation, if necessary. Briefly, however, a bipolar transistor Q1 is connected with its current carrying collector-to-emitter leads between Vcc and the output Vout. Q1's amplification capability is thus in parallel with QP1. Inverter I1 is connected to the input Vin and feeds the control base of Q1, as shown. Inverter I1 simply inverts the input condition at Vin and applies that inverted condition as a control signal at the base of Q1.

Transistor Q1 of Figure 2 is a high current amplifying NPN transistor. Such an element will have a current amplifying gain of $\beta$ as is well known. In normal operation the current amplification is about 90 to 100 at a very high switching speed for a small amount of current applied to the base, or control, lead of transistor Q1. Inverter I1, a narrow channel width fast CMOS inverter, responds quickly to the change in input signal conditions, and supplies the necessary base current needed for Q1 current amplification. Bipolar transistor Q1, when responding to I1, immediately conducts with its high current gain, and thus Vcc is immediately applying a great amount of current to the load. Since the NPN transistor does not pull the load up to Vcc, the element QP1 is used to achieve the full Vcc output voltage at the load.

Transistor Q3 of Figure 2, in short summary, is a load discharge current enhancement and complete discharge to ground is assured by a conductive condition in QN1. Just as where the transistor Q1 has sufficient capability together with QP1 to fully charge the load, QN1 has sufficient conduction capability in combination with Q3 to fully discharge the load to ground. QN2 controls the conduction of Q3 in response to input signals at Vin.

Our invention of Figure 3, by comparison, makes use of smaller sized CMOS elements as are reflected by the numbers given in the drawing of Figure 3 next to the CMOS elements QP1 and QN1. Figure 3 depicts that our P element has a channel width of 90 $\mu$ and our N element has a channel width of 210 $\mu$. This is a fractional ratio of about 1/2 to 1/3 for PMOS to NMOS.

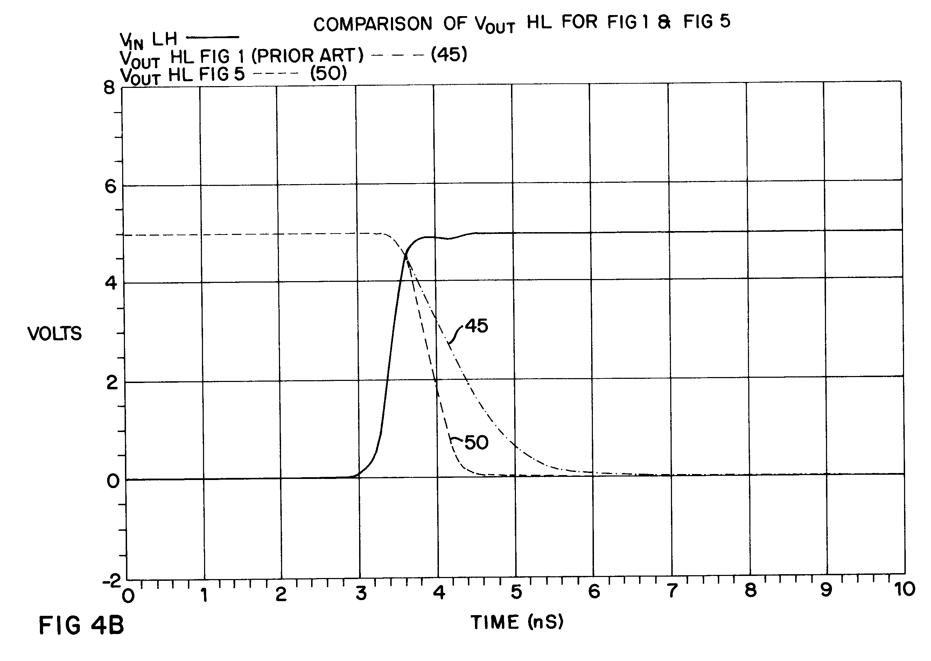

TTL input signals are represented by signal levels of about 0.2 volts for a data "low" input and 3.4 volts for a data "high" input. Vout CMOS operating levels, in contrast, are at ground of 0 volts and a source voltage of Vcc of about 4.5 to 5.5 volts. We have selected the ratio of P to N in order to provide for an input threshold voltage of about 1.5 volts or roughly one-half of the TTL input range. At the same time we select the size of PMOS to be sufficient to meet the Icct specifications. (These typical voltage conditions are shown in Figures 4A and 4B and will be described in more detail in connection with those Figures.).

Conventional P to N ratios of the prior art are about 2/1. Our fractional P/N ratio of about 1/2 to 1/3 P/N, as contrasted with the prior art, shows the novel inventive direction we have gone. Thus, we have moved away from the CMOS input that normally requires twice as much P as N material and have set our input threshold at about 1.5 volts. In so doing, we have equipped our inverter to respond to a TTL threshold input of 1.5 volts and still delver a full CMOS output level.

Although normally one might expect this move toward a smaller PMOS to slow down the circuit operation, we have employed the fast-operating bipolar enhancement to make up for any potential loss of circuit speed. At the same time the size of PMOS that we have selected is not completely satisfactory for meeting the speed required for low to high. Whereas our bipolar enhancer compensates for this loss of speed on the rising edge transition of our output signal.

We will now examine the waveforms of Figures 4A and 4B, in order to more fully appreciate the improved waveforms and operations for the two circuits of our improved hybrid fractional P/N inverter invention of Figure 3 in comparison to the prior art of Figure 1. In summary Figure 4A and 4B depict that we have achieved, in the operating range of about 1.5 volts to about 2.5 volts, an improved operation of about thirty to forty per cent. The more abrupt rise and fall times provide an output condition that more closely mirrors the rise and fall times of the input signal. An improvement in AC characteristics and faster switching at lower input levels with higher output current handling capability has been obtained by our invention.

In Figure 4A, the dash-dotted waveform 30 is a representative approximation of a typical CMOS inverter of a prior art circuit such as shown in Figure 1. We have assumed a TTL input of about 0 to 3 volts and as a test signal we have shown such an input as a sloped line from about time 1.0 to time 4.0. As there shown at time t = 1.0 the input waveform 25 is dropping and the voltage threshold goes from about 3.0 volts to about 0 volts in a time interval of about 2.5 units. During this time interval and at about one-half of the input value, i.e. at about 1.5 volts the threshold switching occurs.

Under somewhat comparable input conditions, a CMOS conduction/non-conduction of a typical prior art Figure 1 are shown by the dash-dotted line 30. Note that a gradual rise in waveform 30 is obtained for the prior art.

As shown in Figure 4A, however, under comparable operating conditions the dashed-lined waveform 40 rises abruptly and more closely follows the abrupt input data signal conditions. Comparison of prior art waveform 30 with the invention's waveform 40 readily depicts the advantages afforded by our invention.

Figure 4B depicts the waveform conditions for the fall times of the output signal. Again the dash-dotted waveform 45 is the prior art. The improvement as shown by the dashed waveform 50 is readily apparent. These improved conditions are obtained as to fall time in the trailing edge by bipolar-enhanced pull-down such as shown and discussed hereinafter in connection with our Figure 5.

In Figure 3 we have lowered the channel width for both QP1 and QN1 in comparison to that of prior art Figure 1. We have measured and compared the Icct current for similar input and output conditions for the circuits of Figure 1 and Figure 3 and in both cases it was about 1.5 milliamperes ("mA"). Thus, our invention demonstrates an improved operation without any increase in Icct.

Icct current and the DC operating characteristics are about the same for Figure 1 and Figure 3. In contrast however, the AC characteristics of the invention of Figure 3 are improved significantly.

Figure 5 is a BiCMOS inverter in accordance with the invention which includes the bipolar-enhanced feature of Figure 3 and additionally includes a bipolar enhanced pull-down (QN5 and Q3) and a Miller killer circuit (QN7). As contrasted from Figure 2 of the Ward and Mentzer circuit which uses an input driven pull-down, our circuit of Figure 5 relies upon a discharge at the load through QN5 to accelerate turn on and enhanced load discharge by Q3.

Figure 5 includes our basic inverter invention of Figure 3 with the bipolar enhanced current feature as provided by bipolar transistor Q4 connected as and functioning the same as transistor Q1 in Figure 3. The circuit operation on pullup for Figure 5 need not be repeated since it is the same as that described for Figure 3.

In Figure 5, however, we also have employed a bipolar current enhanced pull-down by the use of bipolar transistor Q3. QN5 has its source terminal connected to the base of Q3 and its input terminal connected to the input terminal, Vin. In short summary, load discharge current enhancement for Vout is provided by Q3 and complete discharge to ground is assured by a conductive condition in QN3. Just as in Figure 3, where the transistor Q1 had sufficient capability together with QP1 to fully charge the load, QN3 has sufficient conduction capability in combination with Q3 to fully discharge the load to ground. QN3, when conductive, pulls Vout all the way to ground.

Turning now to the more detailed operation of Figure 5, the discharge current enhancement feature will be explained. As a stated fact, QN5 is "on", or conductive, when the input Vin is high and QN5 is "off", or non-conductive, when the input Vin is low. Assume now a new input condition, namely that the input Vin is low but is about to go high. Again the nature of the inverter is such that Vout is at high and is about to go low.

With a low input, QN5 is off and there is no way for Q3 to be on so it also is off. The small inverter 12 may be thought of as a small resistor in the base of Q4, and Q4 is essentially off since it's base and emitter are at the same potential. As the input goes high and the transistor QN5 begins to come on, the inverter 12 is beginning to go low. Q4 is turned off and QN7 begins to turn off.

When 12 goes high, QN7 turns on and turns off Q3. QN7 provides a discharge path for the base of Q3.

QN5, when the output Vout is high, provides base drive to Q3 which rapidly initiates and enhances discharge to ground for the charged load. As the stored energy in the load is being brought back into Q3, Vout continues to fall and will be pulled all the way down to ground through QN3. In short summary, Q3 enhances pull-down by providing an initial load discharge path and the NMOS element QN3 then becomes conductive and assures that Vout is pulled all the way to ground.

QN5 diverts the source of load current from the output and acts as an accelerating feedback transistor for a high to low transition at the output. Q3 gives a boost in the transition, then it stops conduction after Vout goes low. QN5 is thus an output terminal source follower.

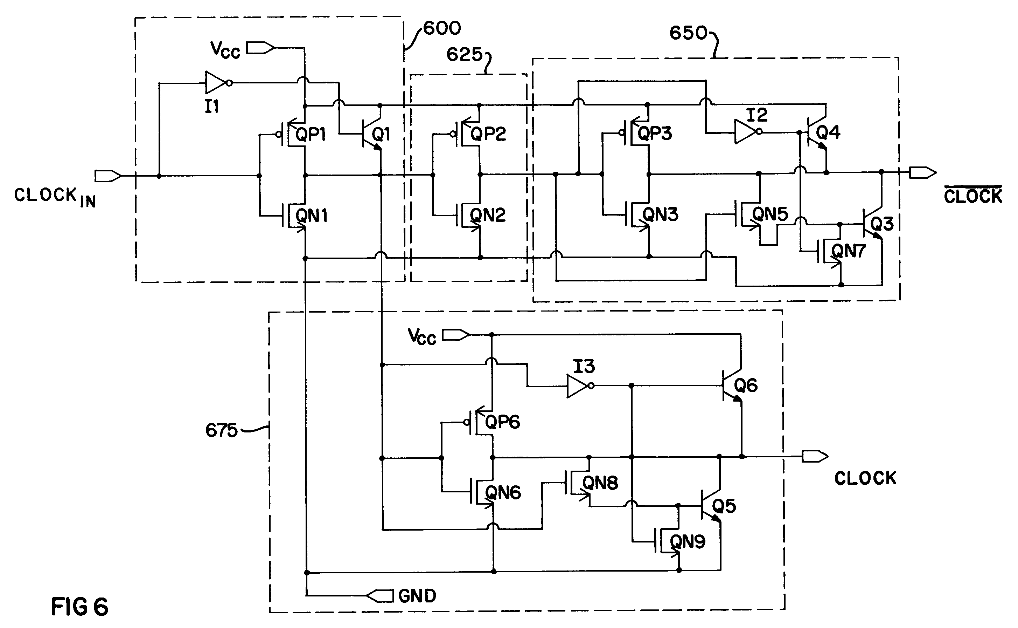

Figure 6 of our invention include a leading edge input stage 600 comprised of our basic inverter circuit of Figure 3. Two clock outputs, shown as CLOCK and $\overline{CLOCK}$ are supplied from two output stages in accordance with our Figure 5. Output signal $\overline{CLOCK}$ is formed by stages connected in tandem and including input stage 600, a propagation signal inverter 625, and an output stage 650. Clock output CLOCK is formed by a single output stage 675 fed from the output of input stage 600. Each stage increases the current driving ability of the circuit. As a result the clock circuit of Figure 6 can drive several other circuits at the same time.

Figure 6 includes, as input stage 600, our basic inverter invention with the bipolar enhanced current pullup feature as provided by bipolar transistor Q1. The input term in Figure 6 is labeled as CLOCKin. Such an input relies upon a TTL threshold which is then translated as described earlier to a CMOS output level. The circuit operation for input stage 600 is the same as the circuit operation previously described in connection with Figure 3, and thus need not be repeated here.

Output stages 650 and 675 of Figure 6, each operate in the manner fully described for Figure 5 and thus need not be described further. Signal characteristics at the output terminals identified as CLOCK and $\overline{CLOCK}$, respectively, include both steep rise and fall times and thus enhanced pullup and pull-down is employed in the output stages. Please refer to Figures 4A and 4B.

Output stages 650 and 675 each include enhanced pullup, and enhanced pull-down. The nature of inverter stages 600, propagation inverter 625, and output stage 650 is such that $\overline{CLOCK}$ is low when the input CLOCKin is high. Thus, the number of inversions for CLOCK out is odd and the output signal is out of phase with the phase of the input signal.

Turning to stage 625, note that the first stage, 625, feeds its output into the input of stage 675. The number of inversions is even and the output CLOCK is in phase with the input CLOCKin.

Example channel widths for the elements of figure 6 are as shown below in table 1.

TABLE 1 (FIGURE 6)

| MOS ELEMENT | CHANNEL WIDTH |
|---|---|
| QP1 | 90 $\mu$ |
| QN1 | 210 $\mu$ |
| QP2 | 120 $\mu$ |
| QN2 | 60 $\mu$ |
| QP3 | 240 $\mu$ |
| QN3 | 120 $\mu$ |
| QN5 | 20 $\mu$ |
| QN7 | 10 $\mu$ |
| QP6 | 200 $\mu$ |
| QN6 | 100 $\mu$ |
| QN8 | 20 $\mu$ |
| QN9 | 10 $\mu$ |
| I1 (P & N not shown but understood) | 12 $\mu$ & 28 $\mu$ |
| I2 ( same ) | 20 $\mu$ & 10 $\mu$ |
| I3( same ) | 20 $\mu$ & 10 $\mu$ |

In summary, our invention mixes TTL and MOS logic elements together in an inverter circuit having a bipolar current enhanced pullup MOS transistor, and a MOS transistor for improved pull-down as well. Increased speed and steep rise and fall times in the output signal are provided. This invention is likewise used as a building block of a clock circuit formed from tandem-connected stages, each of which include a mixture of TTL and CMOS elements connected as a multi-level high speed inverter.

While our invention has been described with reference to a particular example of preferred embodiments, it is our intention to cover all modifications and equivalents within the scope of the following claims. We therefore request that the following claims which define our invention be given the liberal interpretation which is within the spirit and scope of our contribution to this art.

## Claims

1. A mixed-device bipolar and CMOS circuit (BICMOS) comprising:

two series-connected MOS devices (one N and one P) of a small size in order to reduce Icct and to save integrated circuit space, which size reduction tends to slow down the speed of such devices during alternate pullup and pull-down conduction at an output terminal;

means connecting said series-connected MOS devices between a high pullup voltage source and a lower pull-down reference voltage; and

bipolar current enhancement means connected to the output terminal with a current amplification circuit in parallel with the pullup MOS device for delivering, without loss of operational speed expected by the smaller-sized CMOS devices, increased pullup current into a load at the output terminal.

2. A mixed-device BICMOS circuit in accordance with claim 1 and further comprising:

a second bipolar current enhancement means connected to the output with a current amplification circuit in parallel with the smaller-sized pull-down NMOS device for discharging, without loss of operational speed expected by the smaller-sized NMOS device, increased pull-down current from a load into said reference voltage.

3. A mixed-device BICMOS circuit in accordance with claim 1 with enhanced bipolar pullup by said CMOS pullup device, and wherein said bipolar enhancement means further comprises:

a bipolar transistor responding to an inverted form of said signal input at it's control base for providing enhanced pullup.

4. A mixed-device BICMOS circuit in accordance with claim 1 and having further improved response to a low level input voltage signal and a higher level output voltage signal comprising:

a fractional relationship of the ratio of PMOS size to NMOS size for the pullup and pull-down devices in the range of about 1-to-2 to lower the input threshold switching voltage for the circuit.

5. A mixed-device BICMOS circuit in accordance with claim 4 and wherein said fractional relationship provides

a channel width for the PMOS device is narrowed to be about 1/2 to 1/3 channel width of the NMOS device.

6. A mixed device BICMOS circuit in accordance with claim 2 and further comprising,

load discharge conduction means connected to the second bipolar transistor for assuring that both said second bipolar means and said NMOS device fully discharge said load.

7. A mixed-device BICMOS circuit in accordance with claim 1 and adapted for TTL input levels and CMOS output levels and having CMOS pullup and CMOS pull-down transistors with a reduced die area in fabrication, a CMOS-level Vcc and ground, an inverter output terminal and a TTL input terminal for receiving TTL high input level signals which are of a lesser value than the high CMOS level, said inverter having first and second CMOS pullup and pull-down transistors with their drain terminals connected together and to an output terminal for the inverter circuit, said CMOS transistors further having their respective current carrying terminals series-connected between Vcc and ground and their gates connected together and to the inverter input; said BICMOS circuit exhibiting bipolar current enhanced pull-up to speed up the circuit operation, and wherein said bipolar means further comprises:

a bipolar transistor having a control base which is responsive to a threshold input signal about one half the TTL level, and current amplification leads connected between Vcc and the inverter's output terminal; and

a small channel width inverter means connected between said input terminal for receiving said TTL input level signals and applying them in inverted form to the control base of said bipolar transistor.

8. A mixed-device BICMOS circuit in accordance with claim 7 with enhanced bipolar pull-down by said CMOS pull-down device, and further comprising:

a second bipolar transistor having a control base and further having its current carrying leads connected between the hybrid inverter's output terminal and ground; and

means connected between the control base of said second bipolar transistor and the input terminal and accelerating the load discharge to the base of said bipolar transistor for enhanced pull-down via said second bipolar transistor.

9. A mixed-device BICMOS circuit in accordance with claim 7 and further comprising,
alternating conductive conditions of said small-sized CMOS devices to Vcc and to ground for delivering CMOS output signals in response to TTL input signals at said BICMOS input terminal.

10. A BICMOS TTL inverter circuit adapted for TTL input levels and CMOS output levels, said hybrid inverter having a first smaller current carrying capacity primary pullup transistor device of the P-type MOS ("PMOS") coupled to the inverter's output for sourcing charging current to the output from a high level power supply, Vcc; a second relatively large current carrying capacity primary pull-down transistor device of the N-type MOS ("NMOS") also coupled to the hybrid inverter's output for sinking discharge current from the output load capacitance to ground; these two MOS devices alternately being conductive and non-conductive in response to alternating level TTL input signals, said BICMOS inverter including the improvement of:
a bipolar transistor having it's current amplification path coupled between the output terminal and ground; and
means responsive when the output goes from high to low for applying load discharge to the base of said bipolar transistor for bipolar enhanced discharging of the load to ground at least partially through said bipolar transistor.

11. A BICMOS TTL inverter circuit in accordance with claim 10 wherein
said output load is charged from Vcc in a three part sequence in which the charging is first through said bipolar transistor, and then, in a second part, through said bipolar and PMOS device and then completing said charging to Vcc through said PMOS device alone.

12. A BICMOS TTL inverter circuit in accordance with claim 11 wherein said charging sequence for said load provides
said bipolar transistor and said PMOS pullup device are both biased into conductive conditions in response to the same TTL signal input at the BICMOS inverter's input terminal.

13. A BICMOS TTL inverter circuit in accordance with claim 11 with enhanced bipolar pull-down by said CMOS pull-down device, and further comprising:
a second bipolar transistor having a control base and further having its current carrying leads connected between the BICMOS inverter's output terminal and ground; and
means connected between the control base of said second bipolar transistor and the input terminal for enhancing pull-down via said second bipolar transistor in response to a change of CMOS level signal at said hybrid inverter's output terminal.

14. A BICMOS TTL inverter circuit in accordance with claim 11 and further comprising,
alternating conductive conditions of said CMOS devices to Vcc and to ground for delivering CMOS output signals in response to TTL input signals at said BICMOS inverter's input terminal.

15. A BICMOS TTL inverter circuit in accordance with claim 11 having an increased switching speed, and wherein said base control means for said first bipolar transistor comprises;
a small channel width inverter having narrow channel P and NMOS pullup and pull-down devices with their control leads connected together and to said input terminal for said hybrid inverter, their drain terminals connected together and to the base control lead of said bipolar transistor, and their current carrying leads connected between Vcc and ground.

16. A BICMOS TTL inverter circuit in accordance with claim 15 having increased switching speed, and further wherein said narrow-channel inverter,
controls the bipolar transistor to enhance pullup current while allowing the channel width for said CMOS devices to be reduced in comparison with prior art CMOS devices for the same power consumption and switching speed.

17. A BICMOS TTL inverter circuit in accordance with claim 14 and further comprising,
alternating conductive conditions of said CMOS devices to Vcc and to ground for delivering low and high level CMOS output signals in response to high and low level TTL input signals at said BICMOS inverter's input terminal.

18. A BICMOS TTL circuit in accordance with claim 10 wherein said
inverter is a basic building block that can be readily used to form other circuits of improved operation including a clock supply circuit, said clock supply circuit comprising;
signal level translation from TTL input levels to CMOS output levels through at least one stage of inversion.

19. A clock supply circuit in accordance with claim 18 wherein, said clock supply circuit additionally comprises;
an even number of stages of inversion for supplying one phase clock signal; and
an odd number of stages of inversion for supplying another and complementary clock signal as compared with said one phase clock signal.

20. A BICMOS TTL inverter circuit in accordance with claim 19 wherein said hybrid inverter is a basic building block providing
sufficiently high power to deliver complementary clock signals that are increased in power by the individual stages and is further characterized by output stages delivering output signals each having very steep rise and fall times.

21. A TTL to CMOS translating circuit having a TTL input node with input data signals at TTL high and low potential levels, and at least one CMOS output node with output data signals at CMOS high and low potential levels, said circuit having at least one inverter stage respectively coupled between a first high and a second lower reference potential, said stage having a pullup CMOS transistor device coupled to the high potential, a pull-down CMOS transistor device coupled to the lower reference potential, an input terminal and an output terminal, said translating circuit comprising:
a fractional relationship of the ratio of PMOS to NMOS sized devices for the pullup and pull-down devices in the range of about 1-to-2 selected to lower the input threshold switching voltage for the circuit to about one-half of the TTL level.

22. A translating circuit in accordance with claim 21 with enhanced bipolar pullup by said CMOS pullup device further comprising:
a bipolar transistor responding to an inverted form of said TTL input signal at it's control base for providing enhanced pullup.

23. A circuit in accordance with claim 22 with enhanced bipolar pull-down by said CMOS pull-down device, and further comprising:
a second bipolar transistor having a control base and further having its current carrying leads connected between the inverter's output terminal and ground; and
means connected between the control base of said second bipolar transistor and the input terminal for enhancing pull-down via said second bipolar transistor in response to TTL level signals at said hybrid inverter's input terminal and assisted by load discharge for controlling both said second bipolar and said NMOS pull-down device to fully discharge said load.

24. A TTL to CMOS translating circuit having at least one stage in accordance with the translator circuit of claim 21 and further comprising
a first input stage comprised of the translating circuit of claim 21,
at least a second output stage having the output terminal of said first stage feeding the input terminal of the second stage;
said second stage also having a PMOS pullup transistor and an NMOS pull-down transistor;
bipolar current enhancement means having a current amplification path coupled between the PMOS pullup transistor device of said second stage and the high potential;
means turning on the first stage PMOS pullup transistor device with a TTL high potential level signal at the first stage input; and
second bipolar current enhancement means in the second stage having its current amplification path coupled between the second stage output and said reference potential and adapted to turn on the NMOS pull-down transistor device through said second bipolar enhanced means for discharging a load connected to the output terminal and said NMOS transistor device.

**25.** A mixed device bipolar and CMOS (BICMOS) complementary clock circuit comprising:

at least a first input stage responsive to an input signal for a developing a leading edge toggle at said input stage;

an odd and an even number of tandem-connected stage groups connected to and driven by said input stage, with the odd and even number of stages respectively developing in and out of phase complementary clock signals at the output terminal from the last stage in both the odd and even numbered tandem-connected stage groups;

every stage each having at least two series-connected MOS devices (one N and one P) adapted for alternate pullup and pull-down conduction in response to input signals at the respective stage, and having their control leads tied together and to an input terminal, and their drain leads tied together and to an output terminal;

means connecting each of said series-connected MOS devices between a high pullup voltage source and a lower pull-down reference voltage;

at least the input and output stages further having input-signal-responsivebipolar current enhancement means connected to the input and output and with a current amplification circuit in parallel with the pullup MOS side for delivering increased pullup current into a load at the output terminal; and

each of said output stages further having a second input-signal-responsive bipolar current enhancement means connected to the input and output and with a current amplification circuit in parallel with the pull-down MOS side for increased discharging pull-down current from a load into said reference voltage.

**26.** A circuit in accordance with claim 25 with enhanced bipolar pullup by said CMOS pullup device further comprising:

a bipolar transistor responding to an inverted form of said signal input at it's control base for providing enhanced turn on.

**27.** A circuit in accordance with claim 26 and characterized by further improved response to a low level input voltage signal and a higher level output voltage signal comprising:

a fractional relationship of the ratio of PMOS to NMOS sized devices for the pullup and pull-down devices in the range of about 1-to-2 selected to lower the input threshold switching voltage for said circuit.

**28.** A circuit in accordance with claim 27 and adapted for TTL input levels and CMOS output levels and having CMOS pullup and CMOS pull-down transistors, a CMOS-level Vcc and ground, an inverter output terminal and a TTL input terminal for receiving TTL input level signals which are of a lesser value than the CMOS levels, said inverter having first and second CMOS pullup and pull-down transistors with their drain terminals connected together and to an output terminal for the inverter circuit, said CMOS transistors further having their respective current carrying terminals series-connected between Vcc and ground and their control leads connected together and to the inverter input; said BICMOS TTL inverter exhibiting bipolar current enhanced pull-up and wherein said bipolar means further comprises:

a bipolar transistor having a control base which is responsive to the input signal and current amplification leads connected between Vcc and the inverter's output terminal; and

a small channel width inverter means connected between said input terminal for receiving said TTL input level signals and applying them in inverted CMOS form to the control base of said bipolar transistor.

**29.** A circuit in accordance with claim 27 with enhanced bipolar pull-down by said CMOS pull-down device, and further comprising:

a second bipolar transistor having a control base and further having its current carrying leads connected between the hybrid inverter's output terminal and ground; and

means connected between the control base of said second bipolar transistor and the input terminal for enhancing pull-down via said second bipolar transistor in response to TTL level signals at said hybrid inverter's input terminal.

**30.** A circuit in accordance with claim 28 and further comprising,

alternating conductive conditions of said CMOS devices to Vcc and to ground for delivering high and low level CMOS output signals in response to high and low level TTL input signals at said hybrid inverter's input terminal.

31. A method of operating a mixed-device bipolar and CMOS circuit (BICMOS) comprising the steps of:

connecting two series-connected MOS devices (one N and one P) between Vcc and ground;

fabricating said MOS devices of a small size in order to reduce Icct and to save integrated circuit space, which size reduction tends to slow down the speed of such devices during alternate pullup and pull-down conduction at an output terminal;

supplying bipolar current enhancement at the output terminal with a current amplification circuit in parallel with the pullup MOS device; and

delivering, without loss of operational speed expected by the smaller-sized CMOS devices, increased pullup current into a load at the output terminal through the MOS and bipolar devices.

32. A method of operating a mixed-device BICMOS circuit in accordance with claim 31 and further comprising:

supplying additional bipolar current enhancement in parallel with the smaller-sized pull-down NMOS device; and

discharging, without loss of operational speed expected by the smaller-sized NMOS device, increased pull-down current from a load into said reference voltage.

33. A method of operating a mixed-device BICMOS circuit in accordance with claim 31 with said bipolar enhancement step for said CMOS device further comprises:

applying an inverted form of an input signal to the bipolar as a control signal; and

providing enhanced turn on of the CMOS pullup device in order to quickly connect the output terminal to the high pull-up voltage source through the current amplification leads of said bipolar transistor for partial charging said load; and

completely charging the load through the PMOS device.

34. A method of operating a mixed-device BICMOS circuit in accordance with claim 31 and comprising the additional steps of:

establishing a fractional relationship of the ratio of PMOS size to NMOS size for the pullup and pull-down devices in the range of about 1-to-2 in order to lower the input threshold switching voltage for the circuit; and

applying as a switching input voltage a voltage level of about one-half of the amount determined by said fractional relationship.

FIG I (PRIOR ART)

FIG 2

V_CCQ

I1

Q1    (90 μ)

QP1

V_IN

V_OUT

FIG 3

QN1    (210 μ)

GNDQ

V_CC

I2

Q4

QP3

V_IN

V_OUT

QN3    QN5    Q3

FIG 5

QN7

GND

COMPARISON OF $V_{OUT}$ LH FOR FIG 1 & FIG 3

$V_{IN}$ HL ——— (25)
$V_{OUT}$ LH FIG 1 (PRIOR ART) — · — · — (30)
$V_{OUT}$ LH FIG 3 — — — — (40)

VOLTS

40

30

25

TIME (nS)

FIG 4A

EP 0 547 501 A2

## COMPARISON OF V$_{OUT}$ HL FOR FIG 1 & FIG 5

V$_{IN}$ LH ———
V$_{OUT}$ HL FIG 1 (PRIOR ART) — — — (45)
V$_{OUT}$ HL FIG 5 ———— (50)

VOLTS

45

50

TIME (nS)

**FIG 4B**

EP 0 547 501 A2

FIG 6